# EUROPEAN PATENT APPLICATION

(11) **EP 4 718 477 A1**
(43) Date of publication of application: **01.04.2026**
(21) Application number: 24275105.5
(22) Date of filing: 27.09.2024
(51) Int. Cl.: H01F 6/04

(54) **CRYOSTAT STRUCTURE AND MAGNETIC RESONANCE DEVICE**

(71) Applicant: Siemens Healthcare Limited, Camberley, Surrey GU15 3YL (GB)
(72) Inventor: Chorley, Simon, Oxford, OX2 9BN (GB)
(74) Representative: Siemens Healthineers Patent Attorneys

(57) **Abstract**

The invention relates to a cryostat structure (30) for a magnetic resonance device (10) comprising: an outer vacuum chamber (42) enclosing a vacuum region (71); a thermal radiation shield (33) arranged within the outer vacuum chamber (42) and configured to encompass a magnet space (72); and a conduit (60) extending through a wall of the thermal radiation shield (33) and fluidly connecting the magnet space (72) and the vacuum region (71) outside the thermal radiation shield (33). The invention also relates to a magnetic resonance device (10) comprising an inventive cryostat structure (30).

## Description

*Independent of the grammatical term usage, individuals with male, female or other gender identities are included within the term.*

The latest generation of magnetic resonance devices strives to avoid large cryogen reservoirs in which superconducting magnet coils are immersed. Some magnetic resonance devices, also referred to as "dry" systems, operate entirely without a liquid cryogen bath for the superconducting magnet coils, which counteracts the rising costs and high energy requirements for the provision of liquid helium. However, compared to "dry" systems, the process of initially cooling a conventional magnet resonance device (or "wet" system) is much easier, because the cryogen reservoir can simply be filled with liquid cryogen. Cryostats for or "wet" systems typically contain a volume of hundreds or thousands of litres of liquid cryogen.

Reducing the time required to achieve a desired vacuum level in cryostats of "dry" systems poses a major challenge. This is partly because the inner vacuum space is difficult to evacuate through a multi-layer insulation that typically covers and encloses a thermal radiation shield surrounding the superconducting magnet coils. The multi-layer insulation accommodates a significant volume (which is displaced by the cryogen vessel in "wet" systems) and tends to release high amounts of gas during evacuation, which complicates the creation of a vacuum inside a vacuum chamber.

In the past, perforated blankets of multi-layer insulation offset or misaligned with respect to one another have been used to improve venting of the space enclosed by the thermal radiation shield. However, the misaligned perforations still provide a significant impedance for gas molecules having to pass through holes in multiple blankets spaced apart by only a few hundred micrometres.

It is an object of the invention to reduce a time required for evacuation of a vacuum region of a magnetic resonance device.

This object is achieved by a cryostat structure and a magnetic resonance device according to the invention. Further advantageous embodiments are specified in the dependent claims.

The inventive cryostat structure is configured for use in a magnetic resonance device. Particularly, the cryostat structure may comprise parts or components required for cooling a magnet arrangement and/or a cold mass of a magnetic resonance device. It is also conceivable that the cryostat structure includes parts or components of the magnet arrangement and/or the cold mass of a magnetic resonance device comprising the inventive cryostat structure.

The magnet arrangement may represent a main magnet of the magnetic resonance device. Particularly, the magnet arrangement may comprise one or more superconducting magnets or one or more superconducting magnet coils of the magnetic resonance device. In a preferred embodiment, the magnet arrangement comprises at least two superconducting magnet coils. The at least two superconducting magnet coils may be rotationally symmetric or comprise rotationally symmetric bodies. It is conceivable that the at least two superconducting magnet coils comprise a cylindrical or solenoidal shape. The terms superconducting magnet and superconducting magnet coil are used interchangeably herein.

The one or more superconducting magnet coils of the magnet arrangement may define a common axis. Preferably, the common axis defined by one or more superconducting magnet coils corresponds to a cylinder axis and/or an axis of rotational symmetry of the main magnet, the magnet arrangement and/or components of the cryostat structure.

According to an embodiment, the one or more superconducting magnet coils are mechanically coupled and/or mechanically connected. Preferably, the one or more superconducting magnet coils are mechanically connected in such a way to form a cohesive or coherent structure.

For example, the one or more superconducting magnet coils may be integrally bonded. Preferably, at least two superconducting magnet coils are integrally bonded to at least one spacer arranged between the at least two superconducting magnet coils. According to an embodiment, the at least two superconducting magnet coils are bond to opposing sides or faces of the at least one spacer via an adhesive, particularly an epoxy resin.

The magnet arrangement may comprise a magnet support structure configured to provide mechanical support to the one or more superconducting magnet coils. Particularly, the magnet support structure may be configured to maintain a predefined spatial arrangement of at least two superconducting magnet coils. According to an embodiment, the magnet support structure is configured to be mechanically connected to a support structure, particularly an outer vacuum chamber, of a magnetic resonance device comprising the inventive cryostat structure.

In a preferred embodiment, the magnet arrangement is configured to provide a magnetic field suitable for use in a magnetic resonance imaging examination. Particularly, the magnet arrangement may be configured to provide a static or main magnetic field (i. e. a B0-field) within an imaging region of the magnetic resonance device. It is conceivable that the magnet arrangement is configured to generate a main magnetic field having a maximum magnetic field strength between 0.1 and 9 Tesla, for example about 0.5 Tesla, 1.5 Tesla, 3 Tesla, or 7 Tesla.

The term cold mass may designate all components of a magnetic resonance device maintained at a temperature level below room temperature for a prolonged period of time. For example, the cold mass may comprise a thermal radiation shield, a second thermal radiation shield, a magnet support structure, a superconducting magnet coil, a thermal buffer, and the like.

The cryostat structure may comprise a cryocooler configured to maintain a superconducting magnet coil of the magnet arrangement at a temperature close to or lower than a superconducting temperature of a superconducting material of the superconducting magnet coil. For example, the superconducting temperature of the at least one superconducting magnet may be in the range of 3 K to 100 K, preferably in the range of 3 K to 6 K, 5 K to 10 K, 30 K to 60 K, 60 K to 90 K, or 90 K to 120 K. In certain embodiments, the cryocooler may be implemented as a pulse tube refrigerator, a Gifford-McMahon refrigerator, a Stirling cryocooler, a Joule-Thomson cryocooler, or the like.

In a preferred embodiment, the cryocooler is thermally and mechanically connected to at least one superconducting magnet coil via a thermal bus. For example, the thermal bus may comprise or consist of a solid thermal conductor configured to thermally and mechanically connect the cryocooler to the at least one superconducting magnet. Particularly, the thermal bus may be configured to thermally and mechanically connect a cooling stage of the cryocooler to the at least one superconducting magnet. According to an embodiment, the thermal bus may be configured to thermally and mechanically connect the at least one superconducting magnet coil to a heat exchanger of a cold head of the first cryocooler, particularly a heat exchanger of a second stage of the cold head of the first cryocooler.

The cryocooler may comprise a cold head with one or more cooling stages. In case the cold head comprises multiple cooling stages, each cooling stage may have a different temperature level. For example, the cold head of the cryocooler may comprise a first stage and a second stage. The second stage may be thermally and mechanically connected to the at least one superconducting magnet coil. The first stage may be thermally and mechanically connected to a component of the cold mass different from the at least one superconducting magnet coil. Preferably, a temperature level of the first stage exceeds a temperature level of the second stage. For example, the first stage may be configured to provide a temperature in the range between 30 K to 180 K, preferably in the range between 30 K to 60 K, 60 K to 100 K, or 100 K to 180 K. The second stage may be configured to provide a temperature level close to the superconducting temperature of the at least one superconducting magnet coil.

The cryostat structure comprises an outer vacuum chamber enclosing a vacuum region and a thermal radiation shield arranged within the outer vacuum chamber and configured to encompass a magnet space.

The outer vacuum chamber may represent a vessel which is substantially impermeable to fluids, such as a liquids or gases, particularly gaseous cryogens. The outer vacuum chamber may enclose components of the cold mass, such as the thermal radiation shield, a second thermal radiation shield, the magnet support structure, the magnet arrangement, and the like. The vacuum chamber may represent a double-walled hollow cylinder comprising an outer shell and an inner shell. The outer shell and the inner shell of the vacuum chamber may be connected by annular end pieces. The magnet arrangement, particularly the main magnet, may be enclosed between the outer shell and the inner shell of the outer vacuum chamber. The inner shell of the outer vacuum chamber may correspond to a patient bore of a magnetic resonance device comprising the inventive cryogenic system.

The magnet space may be configured to accommodate at least a part of the magnet arrangement. For example, the magnet space may be shaped and/or configured to accommodate one or more superconducting magnet coils, particularly one or more superconducting magnet coils of an inner magnet of a magnetic resonance device. It is also conceivable that the magnet space is configured to accommodate at least a part of the magnet support structure. The magnet space may correspond to an inner volume enclosed by the thermal radiation shield. However, the magnet space may also correspond to an inner volume enclosed by a second thermal radiation shield arranged within a volume enclosed by the thermal radiation shield. The magnet space may represent an at least partially segregated volume within the vacuum region enclosed by the outer vacuum chamber.

The thermal radiation shield may be configured to reduce a transport of thermal energy to the magnet space. Particularly, the thermal radiation shield may be configured to reduce a transport of thermal energy to one or more superconducting magnet coils arranged within the magnet space. A transport of thermal energy may be characterized by a heat transport mechanism such as thermal radiation, thermal conduction, but also thermal convection. The thermal radiation shield, particularly an outer wall of the thermal radiation shield, may circumferentially encompass the magnet space.

The thermal radiation shield may form a vessel enclosing the magnet space, but also a second thermal radiation shield. In a preferred embodiment, the thermal radiation shield comprises an outer wall, an inner wall and annular end walls connecting the outer wall and the inner wall. Particularly, the thermal radiation shield may form a double-walled hollow cylinder enclosing the magnet space, but also the second thermal radiation shield, between the outer wall, the inner wall and the annular end walls. According to an embodiment, one or more superconducting magnet coils are arranged within the magnet space between the outer wall and the inner wall of the thermal radiation shield. For example, the one or more superconducting magnet coils may be enclosed in the vessel formed by the outer wall, the inner wall as well as the annular end walls of the thermal radiation shield.

The thermal radiation shield may comprise an axis of rotational symmetry oriented in parallel to or corresponding to an axis of rotational symmetry defined by one or more superconducting magnet coils of the magnet arrangement.

Preferably, the thermal radiation shield comprises or consists of a material with a high electrical conductivity and/or a high thermal conductivity. For example, the thermal radiation shield may consist of copper or aluminium, particularly high purity aluminium. The thermal radiation shield may also comprise gold, platinum, silver, or other metals with a high electrical conductivity and/or high thermal conductivity. In one embodiment, the thermal radiation shield is coated or galvanized with a material having a high electrical conductivity and/or high thermal conductivity.

The thermal radiation shield may be configured to shield a superconducting magnet coil arranged within the magnet space from (electro-)magnetic fields, particularly an electromagnetic field generated by a gradient system of a magnetic resonance device. For example, the thermal radiation shield may be configured to allow for eddy currents or screening currents to be generated along an electrically conducting surface of the thermal radiation shield in dependence of the electromagnetic field. Particularly, the thermal radiation shield may comprise an electrically conductive layer allowing for a generation of eddy currents in dependence of a primary electromagnetic field, e. g. a gradient magnetic field, particularly a stray field of a gradient magnetic field. The generated eddy currents may generate a secondary (electro-)magnetic field opposing the primary electromagnetic field. Particularly, the primary electromagnetic field and the secondary electromagnetic field may cancel each other out to some extent, thus providing a shielding effect.

According to the invention, the cryostat structure comprises a conduit extending through a wall of the thermal radiation shield. The conduit fluidly connects the magnet space and the vacuum region outside the thermal radiation shield.

The conduit may represent a feedthrough or duct configured to fluidly connect the magnet space and the vacuum region outside the thermal radiation shield. The conduit may extend through a wall and/or a material of the thermal radiation shield. For example, the conduit may extend through a material of the thermal radiation shield, but also a multi-layer insulation covering the thermal radiation shield. In certain embodiments, the conduit may be configured as a pipe, a channel, a duct, a sleeve, a tube, or the like.

In a preferred embodiment, the conduit is configured in such a way to prevent a direct pathway from the vacuum region outside the thermal radiation shield to the magnet space. Particularly, the conduit may be configured to provide a low impedance path for gas molecules travelling through the conduit, while preventing thermal radiation to enter the magnet space from the vacuum region outside the thermal radiation shield along a direct or linear pathway. It is conceivable that the conduit is configured in such a way to prevent a direct line of sight or a direct pathway that would allow thermal radiation emitted by a wall of the outer vacuum chamber to directly enter the magnet space or directly "shine" on a component of the magnet arrangement accommodated within the magnet space.

According to a preferred embodiment, the conduit comprises a material having a high emissivity or a high absorptivity. Thus, the conduit may favourably prevent thermal radiation from being transmitted through the conduit by reflection inside the conduit (like a waveguide for thermal radiation).

The conduit may extend through other components of the cryostat structure and/or the magnet arrangement to fluidly connect the magnet space and the vacuum region outside the thermal radiation shield. For example, the conduit may be configured to extend through a second thermal radiation shield, but also a part of the magnet support structure.

An inventive cryostat structure may favourably improve a performance of pumping equipment for evacuating the vacuum region inside the outer vacuum chamber by providing a conduit configured to fluidly connect the magnet space and the vacuum region outside the thermal radiation shield. The conduit may reduce an impedance or pumping resistance of an evacuation path between the magnet space and the pumping equipment. Thus, a time required for evacuating the vacuum region and/or costs associated with the generation of a desired vacuum within the vacuum region may favourably be reduced compared to conventional cryostat structures.

An inventive cryostat structure may favourably allow for the magnet space to be pumped down more quickly, thus reducing production lead times for magnetic resonance devices, but also energy expenditures associated with the operation of the pumping equipment.

Furthermore, an inventive cryostat structure may allow for a reduced pressure gradient between the pumping equipment and the magnet space, which may favourably accelerate outgassing processes of materials within or around the magnet space (e. g. the multi-layer insulation or walls of the thermal radiation shield) and allow for contaminants to be removed from the vacuum region more quickly.

According to an embodiment of the inventive cryostat structure, the conduit is shaped in such a way to prevent thermal radiation from passing from the vacuum region outside the thermal radiation shield to the magnet space along a linear pathway.

A linear pathway may represent a direct pathway or a linear trajectory. For example, the conduit may be shaped in such a way to prevent a direct line of sight from a wall of the outer vacuum chamber to the magnet space. Particularly, the conduit may be shaped in such a way to prevent thermal radiation from passing or travelling through the conduit along a direct pathway or a linear trajectory.

According to an embodiment, the conduit comprises a tubular section. Particularly, the conduit may be configured as a tube or a pipe.

The tubular section may comprise a polygonal or an oval cross-section. In a preferred embodiment, the tubular section comprises an ellipsoid or a circular cross-section.

The conduit may be configured as a tube comprising one or more bends or angles configured to prevent thermal radiation from passing through the conduit along a linear pathway or a direct line of sight (e. g. without interacting with a wall of the conduit). The one or more bends or angles may cause a trajectory or an extension of the conduit to change in two dimensions or in three dimensions. For example, the conduit may comprise one or more bends or angles extending along a two-dimensional plane. However, the conduit may also comprise one or more bends extending in three dimensions. For example, the conduit may comprise a spiral section, a helical section and/or a staircase section.

It is also conceivable that the conduit comprises one or more cross-sectional constrictions (e. g. reductions in diameter) configured to prevent thermal radiation from directly passing through the conduit.

According to an embodiment, the tubular section comprises a diameter in the range of 10 mm to 50 mm. The diameter of the tubular section may correspond to an average diameter, an equivalent diameter, or a hydraulic diameter of the tubular section.

A conduit having a diameter of less than 50 mm may favourably provide a limited opening cross section for thermal radiation to enter.

A tubular or pipe-shaped conduit may be easy to manufacture and reduce an effort and/or costs associated with manufacturing of an inventive cryostat structure. Furthermore, a tubular or pipe-shaped conduit may favourably facilitate a process of installing the conduit within the inventive cryostat structure.

In providing a conduit shaped in such a way to prevent a direct pathway from the vacuum region outside the thermal radiation shield to the magnet space, an impedance of an evacuation pathway may favourably be reduced while preventing thermal radiation from directly passing through the conduit.

According to an embodiment of the inventive cryostat structure, the conduit comprises at least one bend or angle configured to prevent thermal radiation from passing through the conduit along a linear pathway.

Particularly, the at least one bend or angle may be configured to prevent thermal radiation from passing or travelling through the conduit along a linear pathway or in an unobstructed manner. It is conceivable that the at least one bend or angle of the conduit is configured to prevent thermal radiation from shining through the conduit. For example, the conduit may comprise a bend having at least one angle in the range of 90° to 180°. It is also conceivable that the conduit comprises at least two bends, each bend having an angle of at least 45° to 135°.

The conduit may comprise one or more bends or angles according to an embodiment described above.

In providing a conduit comprising at least one bend or angle according to an embodiment described above, an impedance of an evacuation pathway through the conduit may favourably be reduced while effectively preventing thermal radiation from directly passing through the conduit. A tubular or pipe-shaped conduit comprising one or more bends or angles may be easier to manufacture and/or provide a lower impedance evacuation path in comparison to embodiments of the conduit comprising a baffle structure.

According to a preferred embodiment of the cryostat structure, the at least one bend or angle is arranged at an end of the conduit directed towards the vacuum region outside the thermal radiation shield.

The bend or angle may be arranged at a warm end of the conduit. Particularly, the bend or angle may be arranged at an end of the conduit arranged within the vacuum region outside the thermal radiation shield.

In providing a conduit comprising a bend arranged at an end of the conduit directed towards the vacuum region outside the thermal radiation shield, thermal radiation emitted by a wall of the outer vacuum chamber may favourably be prevented or impeded from entering the conduit. Particularly, a heating of the conduit via thermal radiation may favourably be restricted to a section or end of the conduit arranged within the vacuum region outside the thermal radiation shield.

In certain embodiments, the conduit may comprise a bend or angle arranged at an end of the conduit directed towards the magnet space. For example, the bend or angle may be arranged at a cold end of the conduit. Particularly, the bend or angle may be arranged at an end of the conduit arranged within the magnet space enclosed by the thermal radiation shield.

It is also conceivable that the conduit comprises a first bend and a second bend. The first bend may be arranged at an end of the conduit arranged within the vacuum region outside the thermal radiation shield, and the second bend may be arranged at an end of the conduit arranged within the magnet space enclosed by the thermal radiation shield.

According to a further embodiment of the inventive cryostat structure, the conduit comprises a baffle structure configured to prevent thermal radiation from passing through the conduit along a linear pathway.

For example, the baffle structure may be configured to prevent a linear pathway between the outer vacuum chamber wall and the magnet space. Preferably, the baffle structure is configured to prevent thermal radiation from passing through the conduit along a linear trajectory or a direct pathway.

The baffle structure may be arranged within a volume enclosed by the conduit. Preferably, the baffle structure comprises one or more baffle elements configured to prevent thermal radiation from directly passing through the conduit. However, the baffle structure may also be arranged outside the volume enclosed by the conduit. For example, the baffle structure may comprise a disc or a cap of any suitable geometry covering at least one opening of the conduit. The disc or cap may be attached to conduit by any suitable mounting mechanism.

For example, the baffle structure may comprise one or more deflection plates or baffle plates. The deflection plates or baffle plates may be attached to an interior surface of the conduit. Preferably, the conduit comprises at least two deflection plates or baffle plates offset from each other in such a way to prevent any linear pathway through the conduit. For example, the at least two deflection plates or baffle plates may be arranged at opposing sides within the conduit. The at least two deflection plates or baffle plates may partially overlap along a cross-section of the conduit. For example, the conduit may comprise a first deflection plate and a second deflection plate arranged in such a way that a projection of a main surface of the first deflection plate along an axis of the conduit in the direction of the second deflection plate has a non-empty intersection with a main surface of the second deflection plate.

It is also conceivable that the baffle structure comprises a filler material configured to prevent thermal radiation from directly passing through the conduit. For example, the filler material may comprise grains, balls and/or fibres arranged within the conduit. Preferably, the filler material consists of materials with a low thermal conductivity, such as plastics or composite materials comprising plastics, glass fibres, or carbon fibres.

A baffle structure may favourably increase an effectiveness of preventing thermal radiation from passing through the conduit. Particularly, a baffle structure may favourably allow adjusting of a desired effectiveness of preventing thermal radiation from passing through the conduit by choosing a number, a specific geometric design and/or a specific arrangement of the baffle elements.

According to an embodiment of the inventive cryostat structure, the conduit is mechanically attached to the radiation shield.

The conduit may represent a structure separate from the thermal radiation shield and/or a multi-layer insulation covering the thermal radiation shield. For example, a material of the conduit may differ from a material of the thermal radiation shield and/or the multi-layer insulation.

The conduit may be mechanically connected to the thermal radiation shield and/or the multi-layer insulation via a form-locking connection, a force-locking connection and/or a material bond. For example, the conduit may be screwed, bolted, clamped or glued to the thermal radiation shield and/or the multi-layer insulation. In certain embodiments, the conduit is attached to the thermal radiation shield by bonding, welding or a dedicated fixing.

According to an embodiment, the conduit is mechanically and thermally connected to the thermal radiation shield. A thermal and mechanical connection between the conduit and the thermal radiation shield may allow for thermal energy to be transferred from the conduit to the thermal radiation shield. For example, the conduit may be soldered or welded to the thermal radiation shield. It is also conceivable that the conduit is attached to the thermal radiation shield via a thermally conductive adhesive. Furthermore, a heat conducting surface of the conduit may be in direct contact with a heat conducting surface of the thermal radiation shield to allow for thermal energy to be transferred from the conduit to the thermal radiation shield.

In mechanically attaching the conduit to the thermal radiation shield, but also the multi-layer insulation, a slipping of the conduit relative to the thermal radiation shield may be prevented and a robust and reliable operation of the conduit may be ensured. Furthermore, a conduit mechanically attached to the thermal radiation shield may favourably improve or facilitate an attachment of a multi-layer insulation to the thermal radiation shield.

In mechanically and thermally connecting the conduit to the thermal radiation shield, thermal energy may be transferred from the conduit to the thermal radiation shield and any undesired rise in temperature of sections of the conduit close to the magnet space may favourably be prevented.

In a further embodiment, the inventive cryostat structure comprises a multi-layer insulation covering a surface of the thermal radiation shield. The conduit extends through the multi-layer insulation and is interfaced with the multi-layer insulation by one or more sleeves interleaved with layers of the multi-layer insulation.

A multi-layer insulation (MLI) may represent a type of thermal insulation material used in magnetic resonance devices and other cryogenic applications. Multi-layer insulation may consist of alternating layers (e. g. blankets) of thin reflective foil and low-conductivity spacers, such as netting or paper. For example, the multi-layer insulation (MLI) may consist of several layers of metal-vaporized plastic foils, which are kept at a distance by the spacers. The plastic foils may consist of a polyester or polyimide sheet which is aluminised on both sides. The spacers may consist of woven or non-woven sheets or gauzes made from polyester, polyimide or other material having a low thermal conductivity. The multi-layer insulation may be configured to reflect incoming thermal radiation from a wall of the outer vacuum chamber, and to establish a stable thermal gradient between the outer vacuum chamber and the thermal radiation shield.

The multi-layer insulation may be wrapped around an outer surface of the thermal radiation shield, e. g. a surface of the thermal radiation shield facing towards the outer vacuum chamber. Preferably, the multi-layer insulation comprises one or more holes extending through the multi-layer insulation. The one or more holes may be arranged in such a way to match a spatial arrangement of one or more conduits. Particularly, the one or more holes may be configured to accommodate the one or more conduits in such a way that the one or more conduits extend through the one or more holes in the multi-layer insulation when the multi-layer insulation is appropriately arranged on the surface of the thermal radiation shield.

The one or more sleeves may correspond to small patches or blankets of multi-layer insulation or a different thermal insulation material. In an example, the one or more sleeves may comprise the shape of a cone or a disc. Preferably, the one or more sleeves comprise a flexible material configured conform to an outer surface or outer circumference of the conduit. The one or more sleeves may comprise a hole configured to accommodate the conduit. According to an embodiment, a dimension of the holes in the one or more sleeves is matched with or slightly undersized in comparison to a diameter of the conduit to provide a tight seal around the conduit and prevent thermal radiation from passing through a gap between the conduit and the one or more sleeves.

According to an embodiment, the cryostat structure comprises a plurality of sleeves, each sleeve being interleaved with a different layer or blanket of the multi-layer insulation.

According to an embodiment, one or more layers of the multi-layer insulation protrude between one or more sleeves enclosing the conduit. Particularly, the one or more layers of the multi-layer insulation may protrude between one or more sleeves in proximity to the conduit or in proximity to an interfacial area between the conduit and the one or more sleeves. However, the one or more sleeves may also comprise a conical shape or a patch-shape. Thus, the one or more layers of the multi-layer insulation may protrude between one or more sleeves at a distance to the conduit. For example, sections of the one or more sleeves may protrude between layers of the multi-layer insulation.

In interfacing the conduit with the multi-layer insulation by one or more sleeves interleaved with blankets of the multi-layer insulation, gaps between the conduit and the multi-layer insulation allowing thermal radiation to pass through may favourably be reduced or prevented.

According to a further embodiment, the inventive cryostat structure comprises a multi-layer insulation covering a surface of the thermal radiation shield. The conduit is arranged in such a way that a section of the conduit extends in parallel to the surface of the thermal radiation shield along a section of the surface of the thermal radiation shield. The conduit extends through a hole in the multi-layer insulation and a hole in the thermal radiation shield, wherein the hole in the multi-layer insulation is offset with respect to the hole in the thermal radiation shield.

The multi-layer insulation may be configured in accordance with an embodiment described above.

The surface of the thermal radiation shield may represent an outer surface of the thermal radiation shield.

It is conceivable that the conduit comprises one or more bends according to an embodiment described above. For example, the conduit may comprise a first bend and a second bend. The first bend may be arranged near a section of the conduit extending through the thermal radiation shield. The second bend may be arranged near an end of the conduit directed towards the vacuum region outside the thermal radiation shield. However, the first bend and the second bend may also be arranged at different sections of the conduit. In a further example, the first bend is arranged near a section of the conduit extending through the hole in the multi-layer insulation, whereas the second bend is arranged near a section of the conduit extending through the hole in the thermal radiation shield.

The first bend and the second bend may be connected via the section of the conduit extending in parallel to the surface of the thermal radiation shield along the section of the surface of the thermal radiation shield. The first bend and the second bend may each comprise a bending angle in the range of 45° to 135°, 60° to 120°, or preferably about 90°.

The hole in the multi-layer insulation and the hole in the thermal radiation shield may be misaligned. For example, the hole in the multi-layer insulation and the hole in the thermal radiation shield may be arranged on different radial planes and/or different cross-sectional planes defined by the thermal radiation shield.

The section of the conduit extending in parallel to the surface of the thermal radiation shield along the section of the surface of the thermal radiation shield may be arranged or sandwiched between a wall of the thermal radiation shield and one or more blankets of multi-layer insulation. However, the section of the conduit extending in parallel to the surface of the thermal radiation shield along the section of the surface of the thermal radiation shield may also be arranged or sandwiched between multi-layer insulations, e. g. a first multi-layer insulation and a second multi-layer insulation.

For example, layers of the first multi-layer insulation may be arranged between the outer surface of the thermal radiation shield and the section of the conduit extending in parallel to the outer surface of the thermal radiation shield. The layers of the second multi-layer insulation may be arranged in such a way to confine the section of the conduit extending in parallel to the outer surface of the thermal radiation shield in a direction facing towards the outer vacuum chamber.

According to an embodiment, the inventive cryostat structure comprises a multi-layer insulation covering a surface of the thermal radiation shield, wherein the conduit is arranged in such a way that a section of the conduit extends in parallel to the surface of the thermal radiation shield along a section of the surface of the thermal radiation shield and wherein the section of the conduit extending in parallel to the outer surface of the thermal radiation shield is confined by one or more layers of multi-layer insulation from only one side. For example, the one or more layers of multi-layer insulation may be arranged between the section of the conduit extending in parallel to the outer surface of the thermal radiation shield and the outer surface of the thermal radiation shield.

In arranging a section of the conduit in such a way that a section of the conduit extends in parallel to an outer surface of the thermal radiation shield, a process of covering the thermal radiation shield with multi-layer insulation may favourably be facilitated in comparison to embodiments comprising a conduit interfaced with the multi-layer insulation by one or more sleeves interleaved with blankets of the multi-layer insulation. In cases where the section of the conduit extending in parallel to the outer surface of the thermal radiation shield is arranged or sandwiched between a first multi-layer insulation and a second multi-layer insulation, the conduit may simply extend through holes in the multi-layer insulations, such as a first hole in the first multi-layer insulation and a second hole in the second multi-layer insulation. The first hole and the second hole may be misaligned or offset from one another.

Furthermore, an inventive cryostat structure may favourably allow for an adjustment of a temperature gradient across the conduit by defining a length of the section of the conduit extending in parallel to the outer surface of the thermal radiation shield as well as a distance between the holes in the first multi-layer insulation and the second multi-layer insulation.

According to an embodiment of the inventive cryostat structure, the conduit comprises or consists of a material having an intermediate thermal conductivity or a low thermal conductivity.

For example, the conduit may comprise or consist of a material having an intermediate thermal conductivity in the range of 40 *W*/(*m* · *K*) to 100 *W*/(*m* · *K*) at a temperature of 300 K. However, it is also conceivable that the conduit comprises or consists of a material having an intermediate thermal conductivity in the range of 10 *W*/(*m* · *K*) to 40 *W*/(*m* · *K*) at a temperature of 300 K. According to a preferred embodiment, the conduit comprises or consists of a material having a thermal conductivity of about 15 *W*/(*m* · *K*) at a temperature of 300 K.

In certain embodiment, the conduit may comprise or consist of a material having a low thermal conductivity of less than 10 *W*/(*m* · *K*) at a temperature of 300 K.

The conduit may consist of steel or stainless steel. However, the conduit may also comprise or consist of other materials, particularly materials having a low thermal conductivity, such as plastics, carbon, or composite materials, such as glass-fibre reinforced polymers (GFRP) or carbon-fibre reinforced polymers (CFRP). The conduit may comprise a baffle structure according to an embodiment described above. It is conceivable that the baffle structure comprises or consists of one or more of the materials mentioned above.

According to an embodiment, a length of the conduit is as short as possible, and a diameter of the conduit is as large as possible (e. g. within a limit of 10 mm to 50 mm) to improve a thermal conductance of the conduit. Particularly, a length by which the conduit extends into the vacuum region outside the thermal radiation shield and a thermal conductivity of the conduit may be chosen in such a way to provide a sufficiently small temperature gradient between a section of the conduit arranged in the vacuum region outside the thermal radiation shield and the outer vacuum chamber at about 300 K (assuming a predefined diameter of the conduit). Thus, a transfer of heat energy from the outer vacuum chamber to the thermal radiation shield can favourably be limited. The length by which the conduit extends into the vacuum region outside the thermal radiation shield may depend on an acceptable heat-load and the thermal conductivity of the material of the conduit. The materials mentioned above, such as stainless steel, but also glass-fibre reinforced polymers, may favourably meet these requirements.

In providing a conduit comprising or consisting of a material having an intermediate or low thermal conductivity, a heat transport rate through the material of the conduit may favourably be reduced or limited. Thus, heat energy accumulated at an end of the conduit arranged within the vacuum region outside the thermal radiation shield may favourably be absorbed by the cryocooler thermally connected to the thermal radiation shield before reaching the end of the conduit arranged within the magnet space. Furthermore, the length of the conduit may be shorter, thus reducing costs and/or weight associated with the cryostat structure.

According to a further embodiment, the inventive cryostat structure comprises a second thermal radiation shield enclosing the magnet space. The conduit extends through the wall of the thermal radiation shield and a wall of the second thermal radiation shield to fluidly connect the magnet space and a volume within the vacuum region outside the thermal radiation shield.

The second thermal radiation shield may correspond to an inner thermal shield enclosed by the thermal radiation shield according to an embodiment described above. Particularly, the thermal radiation shield may be configured to enclose the second thermal radiation shield between the outer wall, the inner wall, and the annular end walls of the thermal radiation shield.

The outer vacuum chamber may be configured to provide mechanical support to the thermal radiation shield and/or the second thermal radiation shield.

The second thermal radiation shield may be configured to circumferentially encompass the magnet space. For example, the second thermal radiation shield may form a vessel configured to enclose one or more superconducting magnet coils of a main magnet of a magnetic resonance device comprising the inventive cryostat structure.

In a preferred embodiment, the second thermal radiation shield comprises an outer wall, an inner wall and annular end walls connecting the outer wall and the inner wall. Particularly, the second thermal radiation shield may form a double-walled hollow cylinder configured to enclose the main magnet between the outer wall, the inner wall and the annular end walls. A cylinder axis of the second thermal radiation shield may be oriented in parallel to or correspond to an axis of rotational symmetry defined by the one or more superconducting coils of the main magnet and/or the thermal radiation shield.

In a preferred embodiment, the thermal radiation shield corresponds to a primary thermal shield or a 50 K shield of a magnetic resonance device. For example, the thermal radiation shield may be maintained at a temperature between 40 K and 60 K during operation of the magnetic resonance device.

The second thermal radiation shield may be an intermediate thermal shield. For example, the second thermal radiation shield may be maintained at a temperature level between 4 K and 60 K, particularly between 4 K and 50 K. It is conceivable that the second thermal radiation shield is configured to prevent heat energy, particularly thermal radiation, from entering a region enclosed by the second thermal radiation shield (e. g. a region enclosed between the outer wall and the inner wall of the second thermal radiation shield), particularly the magnet space.

The second thermal radiation shield may comprise a coated or galvanized plastic or polymer. For example, a wall of the second thermal radiation shield may consist of an aluminized plastic, such as a polyester film, particularly polyethylene terephthalate (PET), but also other polymers.

The plastic or polymer may be coated, plated, galvanized or laminated with a thermally conductive metal, such as gold, silver, aluminium, copper, or platinum. Preferably, the second thermal radiation shield has a low emissivity, e. g. below 0.1 or below 0.05.

The conduit may extend through the second thermal radiation shield in a similar manner as described with respect to the thermal radiation shield above. In a preferred embodiment, the conduit extends through a dedicated hole in the second thermal radiation shield. It is conceivable that the conduit is held or carried by the thermal radiation shield, but not mechanically attached or fixed to the second thermal radiation shield. However, in certain embodiments, the conduit can be mechanically attached to both the thermal radiation shield and the second thermal radiation shield.

The conduit may be configured to (fluidly) bridge a volume or transition region enclosed by the thermal radiation shield outside the second thermal radiation shield. The transition region may be arranged between an outer wall of the thermal radiation shield and an outer wall of the second thermal radiation shield.

A second thermal radiation shield may act as an additional mechanical barrier for gas molecules and further complicate and/or delay a process of generating a vacuum inside the magnet. In providing an inventive cryostat structure, a shielding of magnet arranged within the magnet space may favourably be improved, while still allowing for gas molecules to leave the magnet space via the low impedance path provided by the conduit.

According to an embodiment of the inventive cryostat structure, the conduit is configured as a one-piece structure and comprises or consists of a material with low thermal conductivity. The conduit may extend through the thermal radiation shield and the second thermal radiation shield.

For example, the conduit may comprise or consist of a material having a thermal conductivity of less than 10 *W*/(*m* · *K*) at a temperature of 300 K. Particularly, the conduit may comprise or consist of plastic, carbon, or a composite material, such as a glass-fibre reinforced polymer (GFRP) or a carbon-fibre reinforced polymer (CFRP).

A one-piece structure may represent a continuous structure or a monolithic structure. For example, a section of the conduit extending through the thermal radiation shield may be mechanically attached to a section of the conduit extending through the second thermal radiation shield. Particularly, the section of the conduit extending through the thermal radiation shield and the section of the conduit extending through the second thermal radiation shield may form a coherent or cohesive structure.

In a preferred embodiment, the conduit may comprise one or more holes or perforations. The one or more holes may perforate a wall or an outer surface of the conduit. The one or more holes may be configured to enable venting of a space arranged between the thermal radiation shield and the second thermal radiation shield. The space arranged between the thermal radiation shield and the second thermal radiation shield may correspond to a transition region arranged between an outer wall of the thermal radiation shield and an outer wall of the second thermal radiation shield.

If the conduit comprises or consists of a material with low thermal conductivity, the conduit may favourably be manufactured as a one-piece or a monolithic structure and still provide enough thermal resistance to prevent or limit a transport of heat energy from the thermal radiation shield to the second thermal radiation shield via heat conduction. Thus, efforts associated with manufacturing and/or assembly of the cryostat structure may favourably be reduced.

According to an embodiment of the inventive cryostat structure, the conduit comprises a first section and a second section separated from each other. The first section extends through the wall of the thermal radiation shield and the second section extends through the wall of the second thermal radiation shield.

Preferably, the conduit comprises a material with high or intermediate thermal conductivity according to an embodiment described above. For example, the conduit may comprise or consist of a material having a thermal conductivity of more than 40 *W*/(*m* · *K*), more than
60 *W*/(*m* · *K*), more than 80 *W*/(*m* · *K*), more than 100 *W*/(*m* · *K*), or more than 120 *W*/(*m* · *K*) at a temperature of 300 K. It is also conceivable that the first section of the conduit consists of a material with high thermal conductivity, whereas the second section of the conduit consists of a material with low thermal conductivity.

The second thermal radiation shield may comprise a material with low thermal conductivity according to an embodiment described above.

The first section and the second section may each be configured in accordance with an embodiment of a conduit described above. The first section may be mechanically attached to the thermal radiation shield and the second section may be mechanically attached to the second thermal radiation shield. Particularly, the first section may be carried by the thermal radiation shield and the second section may carried by the second thermal radiation shield.

The first section and the second section may be separated from each other by a gap, for example a gap of less than 10 mm, less than 8 mm, less than 6 mm, less than 4 mm, or preferably less than 2 mm. It is conceivable that the first section and the second section are aligned along a common axis. For example, the first section and the second section may comprise a substantially cylindrical shape. A cylinder axis of the first section may be oriented in parallel or correspond to a cylinder axis of the second section. Particularly, the first section and the second section may be arranged in such a way that a projection of an opening cross-section of the first section along a surface normal of the opening cross-section of the first section in the direction of the second section has a non-empty intersection with an opening cross-section of the second section.

In a preferred embodiment, the first section and the second section are radially aligned. The first section and the second section may be aligned in parallel to a radial plane and a cross-sectional plane defined by the thermal radiation shield and/or the second thermal radiation shield. Particularly, the first section and the second section may be aligned along a line of intersection between the radial plane and the cross-sectional plane defined by the thermal radiation shield and/or the second thermal radiation shield. However, it is also conceivable that the first section and the second section are misaligned. For example, the first section and the second section may be arranged in different radial planes and/or different cross-sectional planes defined by the thermal radiation shield and/or the second thermal radiation shield.

A conduit comprising a first section and a second section according to an embodiment described above may favourably prevent a thermal short from the thermal radiation shield to the second thermal radiation shield. Thus, a transport of heat energy from the thermal radiation shield to the second thermal radiation shield via thermal conduction may favourably be avoided.

Furthermore, a conduit comprising a first section and a second section according to an embodiment described above may favourably allow for venting a transition region arranged between an outer wall of the thermal radiation shield and an outer wall of the second thermal radiation shield.

The inventive magnetic resonance device is configured to acquire magnetic resonance data from an object positioned within an imaging region of the magnetic resonance device.

Preferably, the magnetic resonance device is configured to acquire magnetic resonance image data, particularly diagnostic magnetic resonance image data, from the object positioned within the imaging region. The object may be an inanimate object or a patient, particularly a human or an animal.

The inventive magnetic resonance device may represent a closed bore scanner. A closed bore scanner may comprise a substantially cylindrical bore circumferentially enclosing the imaging region. The closed bore scanner may comprise a main magnet including one or more solenoidal superconducting magnet coils (or solenoidal superconducting magnets) circumferentially encompassing the imaging region along an axial direction or an axis of rotational symmetry of the cylindrical bore. The one or more superconducting magnet coils may comprise a superconducting wire having a negligible electrical resistance at (or below) a superconducting temperature. A direction of a main magnetic field provided by the one or more superconducting magnet coils may be oriented substantially in parallel to a direction of access of the object to the imaging region and/or the axial direction of the cylindrical bore.

In other embodiments, the inventive magnetic resonance device may be configured as an open bore scanner, a C-type scanner, a single-sided scanner, or the like.

The inventive magnetic resonance device may comprise further components required for a proper operation of the magnetic resonance device. For example, the magnetic resonance device may comprise an outer vacuum chamber, a magnet support structure, one or more thermal radiation shields and/or a magnet arrangement according to an embodiment described above. In certain embodiments, the magnetic resonance device and/or the cryostat structure comprise one or more cryogen vessels or one or more thermal buffers.

A cryogen vessel may be configured for storing or preserving a fluid, particularly a cryogen, at a desired temperature level. Preferably, the fluid or cryogen exhibits a low boiling point. Examples of suitable fluids or cryogens are Argon, Nitrogen, Neon, Helium, or the like. The desired temperature level may substantially correspond to a superconducting temperature of the at least one superconducting magnet.

The inventive magnetic resonance device may represent a "dry" system comprising a minimum of cryogen or no cryogen at all. For example, the inventive magnetic resonance device comprises one or more small cryogen vessels thermally connected to the main magnet via a thermal bus, particularly a solid thermal conductor. The one or more small cryogen vessels may contain a volume of less than 10 I, less than 5 I, or less than 1 I of cryogen. According to an embodiment of the inventive magnetic resonance device, a cryogen vessel is omitted, and the magnet arrangement is cooled entirely via thermal conduction.

A thermal bus or a solid thermal conductor may comprise or consist of a material with high thermal conductivity, such as a metal (e. g. aluminium, copper, silver, gold, or the like), particularly a high-purity metal. The thermal bus or solid thermal conductor may comprise any suitable shape. Preferably, the thermal bus or solid thermal conductor comprises one or more pieces of metal in the shape of a braid, a rod, a plate, a mesh, a rail, or a combination thereof.

The inventive magnetic resonance device comprises a cryostat structure according to an embodiment described above.

The inventive magnetic resonance device shares the advantages of the inventive cryostat structure according to an embodiment described above.

Further advantages and details of the present invention may be recognized from the embodiments described below as well as the drawings. The figures show:
- Fig. 1: a schematic representation of an embodiment of an inventive magnetic resonance device comprising an inventive cryostat structure,
- Fig. 2: a schematic representation of an embodiment of an inventive magnetic resonance device comprising an inventive cryostat structure,
- Fig. 3: a schematic representation of an embodiment of an inventive cryostat structure,
- Fig. 4: a schematic representation of an embodiment of an inventive cryostat structure,
- Fig. 5: a schematic representation of an embodiment of an inventive cryostat structure,
- Fig. 6: a schematic representation of an embodiment of an inventive cryostat structure,
- Fig. 7: a schematic representation of an embodiment of an inventive cryostat structure,
- Fig. 8: a schematic representation of an embodiment of an inventive magnetic resonance device comprising an inventive cryostat structure,
- Fig. 9: a schematic representation of an embodiment of an inventive cryostat structure,
- Fig. 10: a schematic representation of an embodiment of an inventive cryostat structure.

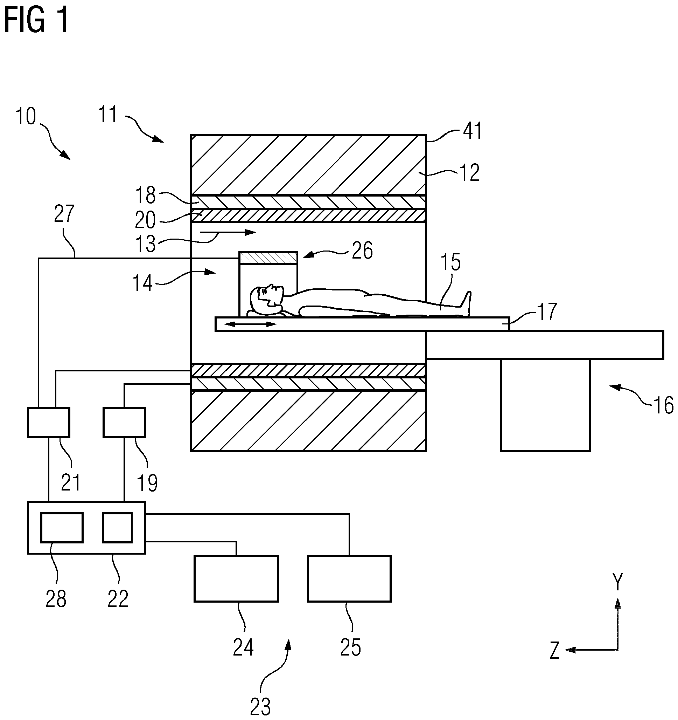

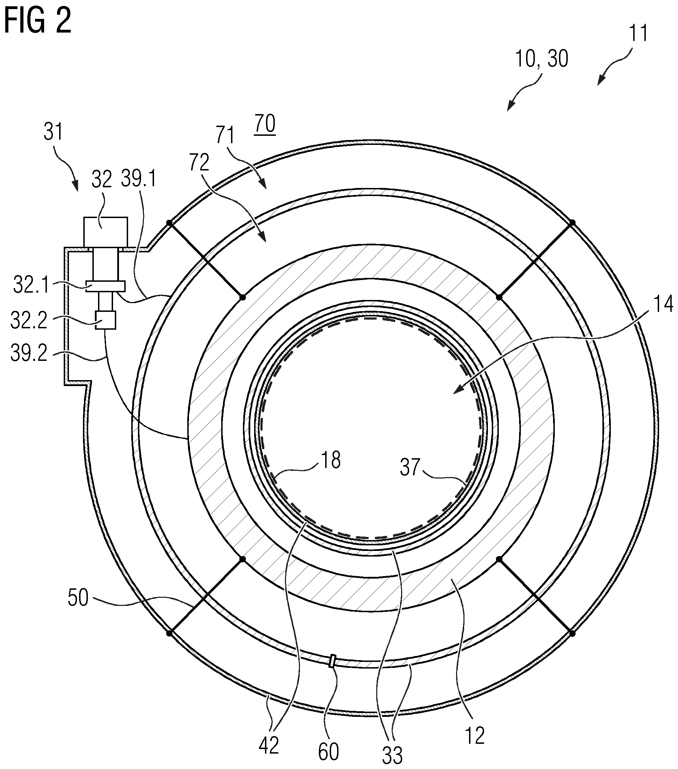

Fig. 1 shows an embodiment of a magnetic resonance device 10 according to the invention. The magnetic resonance device 10 comprises a static field magnet or main magnet 12 including one or more superconducting magnet coils (not shown) configured to provide a homogenous, static magnetic field 13 (B0 field). The static magnetic field 13 permeates an imaging region 14 configured to receive an imaging object, such as a patient 15. The imaging region 14 may correspond to a patient bore 37 (see Fig. 2) configured to accommodate a patient 15 during a magnetic resonance measurement. The imaging region 14 is encompassed by the main magnet 12 in a circumferential direction. The main magnet 12 may form a part of a magnet arrangement 11 according to an embodiment described above.

The magnetic resonance device 10 may comprise a patient positioning device 16 configured to transport the patient 15 into the imaging region 14. Particularly, the patient positioning device 16 may comprise a patient table 17 configured to accommodate the patient 15. Particularly, the patient positioning device 16 may be configured to transport a diagnostically relevant body region of the patient 15 into an imaging volume (not shown) of the magnetic resonance device 10. The magnetic resonance device 10 may comprise a housing 41 concealing components of the magnetic resonance device 10, such as the cryostat structure 30 (see Figures 2 to 10) and the magnet arrangement 11.

The magnetic resonance device 10 may comprise a gradient system including one or more gradient coils 18. The one or more gradient coils 18 may be configured to generate gradient magnetic fields in different, preferably orthogonally oriented, spatial directions. The gradient magnetic fields can be used for spatial encoding of magnetic resonance signals or magnetic resonance data acquired during a magnetic resonance measurement. The one or more gradient coils 18 can be activated or controlled via an appropriate control signal provided by a gradient control unit 19.

The magnetic resonance device 10 may further comprise an integrated radiofrequency antenna 20 (i. e. a body coil). The radiofrequency antenna 20 may be activated or controlled via a radiofrequency control unit 21. Particularly, the radiofrequency control unit 21 may be configured to control the radiofrequency antenna 20 to generate a high frequency magnetic field and emit radiofrequency excitation pulses into the imaging region 14. The magnetic resonance device 10 may further comprise a local coil 26. The local coil 26 may be positioned on or in proximity to a diagnostically relevant body region of the patient 15. The local coil 26 may be configured to emit radiofrequency excitation pulses into the patient 15 and/or receive magnetic resonance signals from the patient 15. It is conceivable, that the local coil 26 is controlled via the radiofrequency controller 21. The local coil 26 and/or the integrated radiofrequency antenna 20 may be connected to the radiofrequency controller 21 via an electrical connection cable 27.

Preferably, the magnetic resonance device 10 comprises a control unit 22 configured to control the magnetic resonance device 10. The control unit 22 may comprise a processing unit 28 configured to process magnetic resonance signals and reconstruct magnetic resonance images. The processing unit 28 may also be configured to process input from a user of the magnetic resonance device 10 and/or provide an output to the user. For this purpose, the processing unit 28 and/or the control unit 22 can be connected to a display unit 24 and an input unit 25 via a suitable signal connection. For a preparation of a magnetic resonance measurement, preparatory information, such as imaging parameters or patient information, can be provided to the user via the display unit 24. The input unit 25 may be configured to receive information and/or imaging parameters from the user. The display unit 24 and the input unit 25 may form a part of a user interface 23 configured to enable the user to interact with the magnetic resonance device 10.

Of course, the magnetic resonance device 10 may comprise further components and/or functions which are common in magnetic resonance devices. The general operation of a magnetic resonance device 10 is known to those skilled in the art and a more detailed description is omitted for sake of brevity.

Fig. 2 shows a sectional view of an embodiment of an inventive magnetic resonance device 10 comprising a cryostat structure 30 according to the invention.

The cryostat structure 30 comprises an outer vacuum chamber 42 providing an outer enclosure for the components of the magnetic resonance device 10, such as the main magnet 12, but also other components of the cryostat structure 30, such as the thermal radiation shield 33. The outer vacuum chamber 42 separates a surrounding environment 70 from a vacuum region 71 encompassed by the outer vacuum chamber 42. In the depicted embodiment, the outer vacuum chamber 42 forms a double-walled hollow cylinder comprising an outer shell and an inner shell. The main magnet 12 and the other components of the cryostat structure 30 may be housed within or enclosed by the outer shell and the inner shell of the outer vacuum chamber 42. The inner shell of the outer vacuum chamber 42 may form a patient bore 37 encompassing the imaging region 14 in a circumferential direction.

The magnetic resonance device 10 may comprise a cryocooler 31 configured to cool the main magnet 12, but also components of the cryostat structure 30. The cryocooler 31 may comprise one or more compressors (not shown) supplying pressurized gas or cryogen to a cold head 32 of the cryocooler 31. The cold head 32 may be mounted on the outer shell of the outer vacuum chamber 42.

In the depicted example, the cold head 32 comprises two cooling stages 32.1 and 32.2. According to an embodiment, a second stage 32.2 of the cold head 32 is thermally connected to the main magnet 12, while a first stage 32.1 of the cold head 32 is thermally connected to a component of the cryostat structure 30, such as the thermal radiation shield 33. The cryocooler 31 may be configured to cool further components of the magnetic resonance device 10 or the cryostat structure 30, such as a cryogen vessel, a thermal buffer (not shown), or the like.

In the depicted embodiment, the thermal radiation shield 33 is configured as a double-walled hollow cylinder. The main magnet 12 is enclosed between an outer wall and an inner wall of the thermal radiation shield 33. Thus, the main magnet 12 is accommodated in a magnet space 72 enclosed between the outer wall and the inner wall of the thermal radiation shield 33.

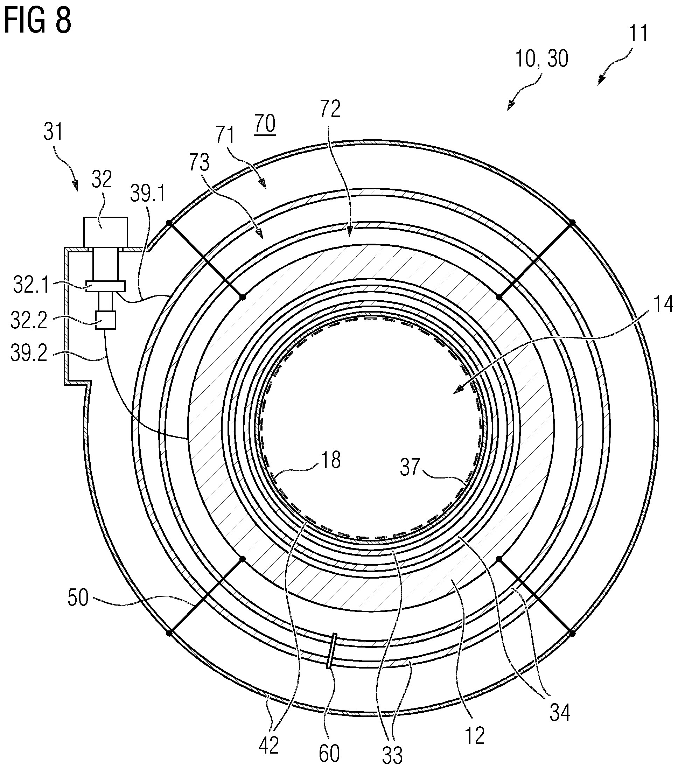

The magnetic resonance device 10 may comprise a support structure configured to mechanically attach the main magnet 12 to the outer vacuum chamber 42. In the depicted example, the magnet arrangement 11 comprises one or more suspension elements 50 or suspension rods configured to suspend the main magnet 12 from the outer shell of the outer vacuum chamber 42. The suspension elements 50 may extend through passages or holes in the thermal radiation shield 33, but also a second thermal radiation shield 34 (see Fig. 8), to provide a mechanical connection between the outer shell of the outer vacuum chamber 42 and the main magnet 12 or a magnet support structure configured to support the main magnet 12.

In one example, the first cooling stage 32.1 of the cryocooler 31 is configured to provide a temperature level of about 43 K, whereas the second cooling stage 32.2 of the cryocooler 31 is configured to provide a temperature level of about 4.2 K. In a preferred embodiment, the first stage 32.1 and the second stage 32.2 of the cryocooler 31 are thermally and mechanically connected to components of the cryostat structure 30 via a thermal bus 39. The thermal bus may comprise one or more solid thermal conductors 39.1, 39.2. It is also conceivable that the magnet arrangement 11 comprises one or more small cryogen vessels and/or one or more thermal buffers (not shown) thermally connected to the cryocooler 31 via a similar thermal bus.

During operation of the magnetic resonance device 10, the thermal radiation shield 33 may be maintained at an intermediate temperature, e. g. a temperature in the range of 40 K to 60 K, preferably about 43 K. The thermal radiation shield 33 may comprise an electrically conductive material configured for shielding the main magnet 12 from thermal radiation, but also from stray fields of the gradient magnetic fields generated via the gradient coils 18.

The cryostat structure 30 comprises a conduit 60 extending through a wall of the thermal radiation shield 33. The conduit 60 is configured to fluidly connect the magnet space 72 and the vacuum region 71 outside the thermal radiation shield 33. The conduit 60 may extend through an inner wall or an outer wall of the thermal radiation shield 33. In the depicted example, the cryostat structure 30 comprises a single conduit 60. However, the cryostat structure 30 may comprise a plurality of conduits 60, each conduit 60 extending through the inner wall or the outer wall of the thermal radiation shield 33.

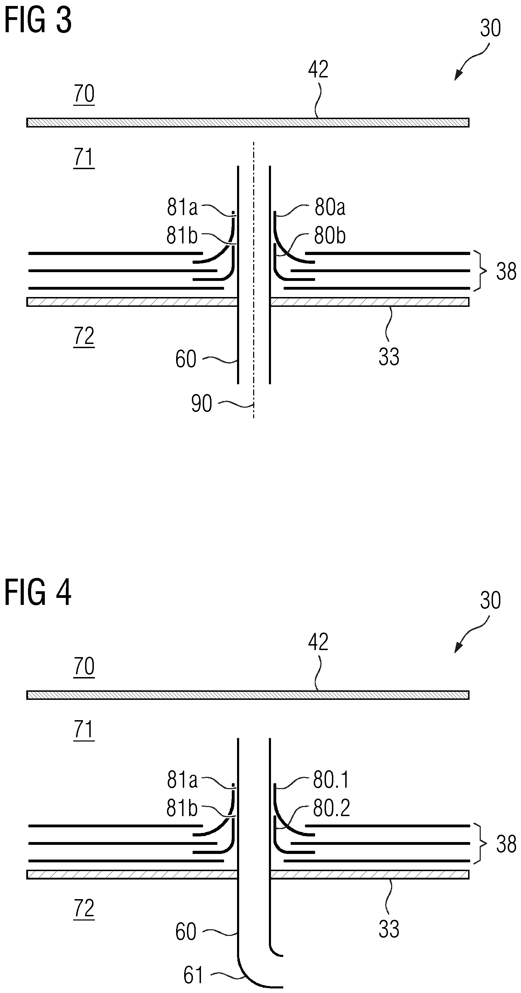

Fig. 3 shows a schematic representation of a section of an embodiment of an inventive cryostat structure 30. The cryostat structure 30 comprises an outer vacuum chamber 42 enclosing a vacuum region 71, a thermal radiation shield 33 arranged within the outer vacuum chamber and configured to enclose a magnet space 72, and a conduit 60 extending through the thermal radiation shield 33 and fluidly connecting the magnet space 72 and the vacuum region 71 outside the thermal radiation shield 33. The components of the cryostat structure 30 may be configured in accordance with the embodiment shown in Fig. 2.

In the depicted example, the conduit 60 comprises a tube. The tube may comprise a diameter in the range of 10 mm to 50 mm. However, the diameter of the tube may be smaller or larger depending on a dimension of the magnetic resonance device 10. In the depicted example, the tube is substantially straight, providing a direct pathway 90 from the vacuum region 71 outside the thermal radiation shield 33 to the magnet space 72. Thus, thermal radiation emitted from a wall of the outer vacuum chamber 42 may travel from the vacuum region 71 outside the thermal radiation shield 33 to the magnet space 72 along a linear or direct pathway 90. However, a cryostat structure 30 according to the embodiment shown in Fig. 3 may significantly reduce an impedance or pumping resistance of an evacuation path between the magnet space 72 and pumping equipment (not shown) connected to the vacuum region 71.

In the present example of the cryostat structure 30, a multi-layer insulation 38 covers an outer surface of the thermal radiation shield 33. The conduit 60 extends through the multi-layer insulation 38 and is interfaced with the multi-layer insulation 38 by one or more sleeves 80a, 80b interleaved with different layers or blankets of the multi-layer insulation 38.

The one or more sleeves 80 may be configured in accordance with an embodiment described above. In the depicted embodiment, the one or more sleeves 80 comprise cone-shaped patches of multi-layer insulation. The one or more sleeves 80 comprise perforations or holes 81a, 81b configured to accommodate the conduit 60.

In certain embodiments, a dimension of the holes 81a, 81b in the sleeves 80a, 80b is matched with or slightly undersized in comparison to a diameter of the conduit 60 to provide a seal around the conduit 60 and prevent thermal radiation from passing through a gap between the conduit 60 and the one or more sleeves 80.

Fig. 4 shows an embodiment of an inventive cryostat structure 30 similar to the embodiment depicted in Fig. 3. In contrast to the embodiment depicted in Fig. 3, the conduit 60 comprises a bend 61 or angle configured to prevent thermal radiation from directly passing through the conduit 60.

In the depicted example, the conduit 60 comprises a bend 61 arranged at an end of the conduit 60 directed towards the magnet space 72. The bend 61 is arranged at an end of the conduit 60 arranged within the magnet space 72 enclosed by the thermal radiation shield 33 (e. g. the "cold end" of the conduit 60). Due to the bend 61, the conduit 60 is shaped in such a way to prevent a linear or direct pathway from the vacuum region 71 outside the thermal radiation shield 33 to the magnet space 72.

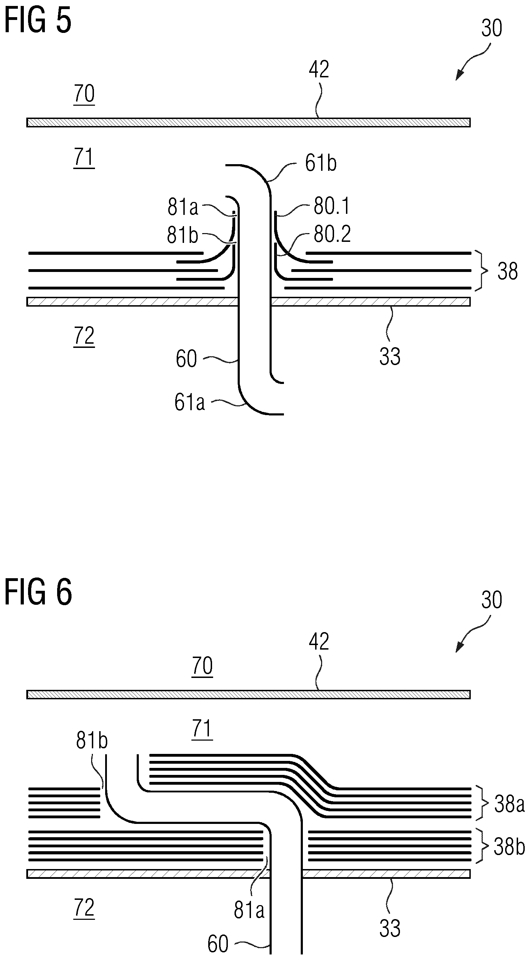

Fig. 5 shows an embodiment of an inventive cryostat structure 30 similar to the embodiment depicted in Fig, 4. In the embodiment shown in Fig. 5, the conduit 60 comprises a first bend 61a and a second bend 61b configured to prevent thermal radiation from directly passing through the conduit 60. The first bend 61a is arranged at an end of the conduit 60 arranged within the magnet space 72 enclosed by the thermal radiation shield 33 (e. g. the "cold end" of the conduit 60), whereas the second bend 61b is arranged at an end of the conduit 60 arranged within the vacuum region 71 outside the thermal radiation shield 33 (e. g. the "warm end" of the conduit 60).

In the embodiments depicted in Figures 4 and 5, the bends 61, 61a and 61b comprise angles of substantially 90°. However, the bending angles of the bends 61, 61a and 61b may be smaller or larger than 90°. Particularly, the conduit 60 depicted in Fig. 5 may comprise two bends 61 comprising bending angles in the range of 45° to 135°. The bends may be oriented in the same or in different directions.

Due to the bends 61, the conduit 60 is shaped in such a way to prevent a direct line of sight (or pathway) from a wall of the outer vacuum chamber 42 to the magnet space 72.

Fig. 6 shows a further embodiment of the inventive cryostat structure 30. In the present example, the cryostat structure 30 comprises a multi-layer insulation 38 covering a surface of the thermal radiation shield 33. The conduit 60 is arranged in such a way that a section of the conduit 60 extends in parallel to the surface of the thermal radiation shield 33 along a section of the surface of the thermal radiation shield 33 and passes through a hole 81 in the multi-layer insulation 38.

The section of the conduit 60 extending in parallel to the surface of the thermal radiation shield 33 is arranged or sandwiched between a first multi-layer insulation 38a and a second multi-layer insulation 38b. The first multi-layer insulation 38a is arranged between the outer surface of the thermal radiation shield 33 and the section of the conduit 60 extending in parallel to the outer surface of the thermal radiation shield 66, whereas the second multi-layer insulation 38b confines the section of the conduit 60 extending in parallel to the outer surface of the thermal radiation shield 33 in a direction facing towards the outer vacuum chamber 42. The conduit 60 extends through a first hole 81a in the first multi-layer insulation 38a and a second hole 81b in the second multi-layer insulation 38b. The first hole 81a and the second hole 81b are offset with respect to each other to prevent thermal radiation from passing through gaps between the multi-layer insulations 38a and 38b and the conduit 60 near the holes 81a and 81b. Particularly, the first hole 81a and the second hole 81b may be located along different radial planes and/or different cross-sectional planes defined by the thermal radiation shield 33.

In the depicted example, the first hole 81a in the first multi-layer insulation 38a is aligned with a hole 82 or perforation in the thermal radiation shield 33 allowing the conduit 60 to pass through. Thus, the second hole 81b in the second multi-layer insulation 38b is offset with respect to the hole 82 in the thermal radiation shield 33.

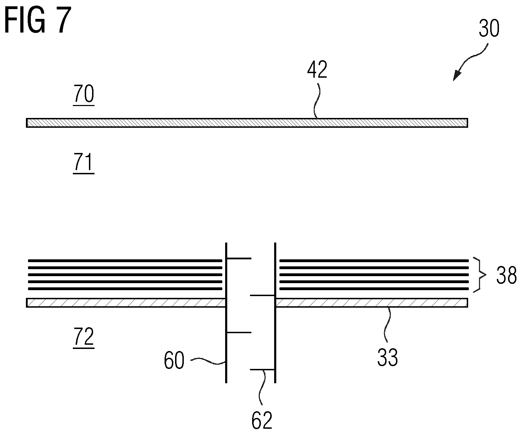

Fig. 7 shows a further embodiment of an inventive cryostat structure 30. In the depicted example, the conduit 60 comprises a baffle structure 62 configured to prevent a direct pathway from the wall of the outer vacuum chamber 42 to the magnet space 72. The baffle structure 62 comprises a plurality of deflection plates attached to an interior surface of the conduit 60. The deflection plates are offset from each other in such a way to obstruct any linear pathway through the conduit 60. Particularly, the deflection plates are arranged alternately at opposing sides within the conduit 60 and partially overlap along a cross-section of the conduit 60.

The conduit 60 may be interfaced with the multi-layer insulation in accordance with an embodiment depicted in one of the Figures 3 to 5. However, it is also conceivable that the conduit 60 including the baffle structure 62 comprises a section extending in parallel along an outer surface of the thermal radiation shield 33 as depicted in Fig. 6. In this case, the conduit 60 may be sandwiched between a first multi-layer insulation and a second multi-layer insulation according to an embodiment described above.

Fig. 8 shows a sectional view of a further embodiment of an inventive magnetic resonance device 10 comprising a cryostat structure 30 according to the invention.

In the depicted example, the cryostat structure 30 comprises a second thermal radiation shield 34 enclosing the magnet space 72. The conduit 60 extends through a wall of the thermal radiation shield 33 and a wall of the second thermal radiation shield 34 to fluidly connect the magnet space 72 and the volume within the vacuum region 71 outside the thermal radiation shield 33.

The second thermal radiation shield 34 is arranged within a volume enclosed by the thermal radiation shield 33. In the present example, the second thermal radiation shield 34 comprises an outer wall, an inner wall and annular end walls (not shown) forming a double-walled hollow cylinder configured to enclose the main magnet 12. In a preferred embodiment, a cylinder axis of the second thermal radiation shield 34 corresponds to an axis of rotational symmetry defined by the one or more superconducting coils of the main magnet 12.

The conduit 60 is configured to (fluidly) bridge the transition region 73 arranged between the outer wall of the thermal radiation shield 33 and the outer wall of the second thermal radiation shield 34.

In the depicted embodiment, the cryostat structure 30 comprises a single conduit 60. However, in all embodiments described herein, the cryostat structure 30 may comprise a plurality of conduits 60 configured in accordance with an embodiment described herein. The plurality of conduits 60 may be distributed in regular or irregular intervals along a circumference of the thermal radiation shield 33 and/or the second thermal radiation shield 34. For example, the cryostat structure 30 depicted in Fig. 8 may comprise one or more further conduits 60, e. g. a conduit fluidly connecting the vacuum region 71 outside the thermal radiation shield 33 and the transition region 73. Such a conduit may be arranged in accordance with the embodiment depicted in Fig. 2.

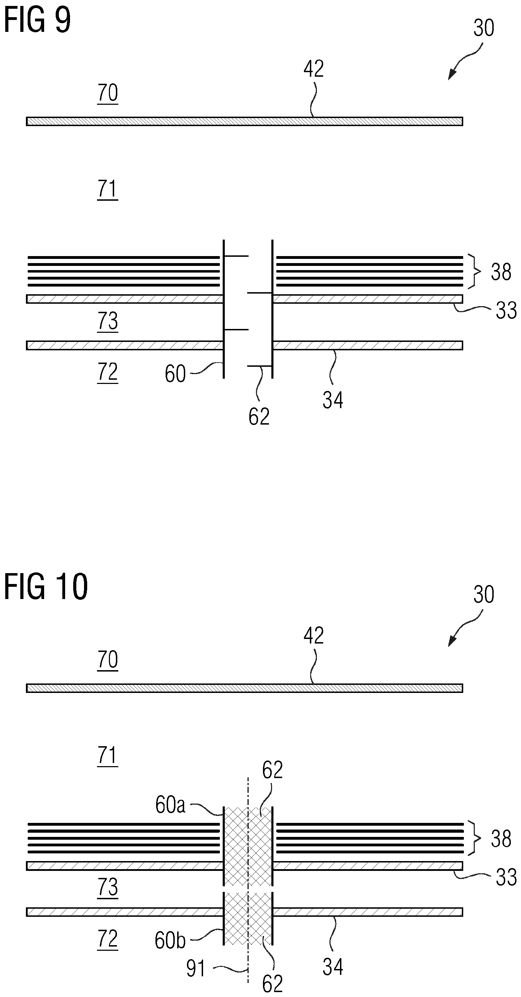

Fig. 9 shows a section of an inventive cryostat structure 30 suitable for use in the embodiment of the magnetic resonance device 10 depicted in Fig. 8. In the present example, the conduit 60 is configured as a one-piece structure which extends through the thermal radiation shield 33 and the second thermal radiation shield 34.

The conduit 60 may be configured as a tube or pipe comprising or consisting of a material with low thermal conductivity according to an embodiment described above. Preferably, the material of the conduit 60 provides enough thermal resistance to limit or prevent a transport of heat energy from the thermal radiation shield 33 to the second thermal radiation shield 34 via heat conduction.

In a preferred embodiment, the second thermal radiation shield 34 comprises a polyester film coated with a thin layer of aluminium. The polyester film may exhibit a low thermal conductivity, thus further limiting a transfer of thermal energy from the conduit 60 to the second thermal radiation shield 34 via heat conduction.

According to an embodiment, a wall of the conduit 60 may comprise one or more holes or perforations (not shown). The one or more holes or perforations may be configured to enable venting of a space or transition region arranged between the thermal radiation shield 33 and the second thermal radiation shield 34.

The conduit 60 depicted in Fig. 9 may be interfaced with the multi-layer insulation 38 covering the thermal radiation shield 33 according to an embodiment described above. It is conceivable that the conduit 60 simply passes through a dedicated hole in the second thermal radiation shield 34. As the conduit 60 is already interfaced with the multi-layer insulation 38, there is no need to provide a dedicated interface between the conduit 60 and the second thermal radiation shield 34.

In the embodiment of the cryostat structure shown in Fig. 10, the conduit 60 comprises a first section 60a and a second section 60b separated from each other. The first section 60a extends through a wall of the thermal radiation shield 33 and the second section 60b extends through a wall of the second thermal radiation shield 34.

The separation of the first section 60a from the second section 60b allows the conduit 60, but also the second thermal radiation shield 34, to comprise or consist of a material having a high or intermediate thermal conductivity according to an embodiment described above. For example, the conduit 60 may consist of steel or stainless steel, which can easily be attached to the thermal radiation shield 33 via a weld joint or a solder joint. Furthermore, metals like steel or stainless steel are more robust against large temperature fluctuations associated with cooling down the cold mass to an operating temperature (e. g. in comparison to plastics or composite materials). Furthermore, steel or stainless steel is structurally more robust and may favourably provide or act as an anchor configured for attaching the multi-layer insulation 38.

In the depicted example, the first section 60a is mechanically attached to the thermal radiation shield 33 and the second section 60b is mechanically attached to the second thermal radiation shield 34. The first section 60a and the second section 60b of the conduit 60 are aligned along a common axis 91. For example, the first section 60a and the second section 60b may be radially aligned. Particularly, the first section 60a and the second section 60b may be aligned along a line of intersection between a radial plane and a cross-sectional plane defined by the thermal radiation shield 33 and/or the second thermal radiation shield 34.

In certain embodiments, the first section 60a and the second section 60b may be arranged in different radial planes and/or different cross-sectional planes of the thermal radiation shield 33 and/or the second thermal radiation shield 34.

In the embodiment depicted in Fig. 10, the first section 60a and the second section 60b of the conduit 60 each comprise a baffle structure 62 consisting of a filler material configured to prevent thermal radiation from directly passing through the conduit. For example, the filler material may comprise a bed of plastic balls. A radius or a distribution of radii of the plastic balls may be adjusted in such a way to achieve a desired compromise between reducing a penetration resistance (or permeability) for gas molecules travelling through the conduit 60 and a permeability for thermal radiation.

In all embodiments described herein, the conduit 60 may be mechanically attached to the thermal radiation shield 33 and/or the second thermal radiation shield 34. For example, one or more conduits 60 may be glued, welded or soldered to the thermal radiation shield 33 and/or the second thermal radiation shield 34. However, the one or more conduits 60 may also be clamped, bolted, screwed or otherwise attached to the thermal radiation shield 33 and/or the second thermal radiation shield 34.

In cases where the cryostat structure 30 comprises a thermal radiation shield 33 and a second thermal radiation shield 34 and the conduit 60 is made from one piece or a continuous structure, the conduit 60 may be mechanically attached to the thermal radiation shield 33 and simply extend through a hole in the second thermal radiation shield 34. In other words, the conduit 60 may be supported by or carried by the thermal radiation shield 33, but not the second thermal radiation shield 34.

The embodiments described herein are to be recognized as examples. It is to be understood that individual embodiments may be extended by or combined with features of other embodiments if not explicitly stated otherwise. The embodiments depicted in the Figures are representations that do not necessarily have to be to scale.

## Claims

1. A cryostat structure (30) for a magnetic resonance device (10) comprising:
• an outer vacuum chamber (42) enclosing a vacuum region (71);
• a thermal radiation shield (33) arranged within the outer vacuum chamber (42) and configured to encompass a magnet space (72); and
• a conduit (60) extending through a wall of the thermal radiation shield (33) and fluidly connecting the magnet space (72) and the vacuum region (71) outside the thermal radiation shield (33).

2. The cryostat structure (30) according to claim 1, wherein the conduit (60) is shaped in such a way to prevent thermal radiation from passing from the vacuum region (71) outside the thermal radiation shield (33) to the magnet space (72) along a linear pathway.

3. The cryostat structure (30) according to one of the claims 1 or 2, wherein the conduit (60) comprises a tubular section.

4. The cryostat structure (30) according to claim 3, wherein the tubular section comprises a diameter in the range of 10 mm to 50 mm.

5. The cryostat structure (30) according to one of the claims 2 to 4, wherein the conduit (60) comprises at least one bend (61) configured to prevent thermal radiation from passing through the conduit (60) along a linear pathway.

6. The cryostat structure (30) according to claim 5, wherein the at least one bend (61) is arranged at an end of the conduit (60) which is directed towards the vacuum region (71) outside the thermal radiation shield (33).

7. The cryostat structure (30) according to one of the preceding claims, wherein the conduit (60) comprises a baffle structure (62) configured to prevent thermal radiation from passing through the conduit (60) along a linear pathway.

8. The cryostat structure (30) according to one of the preceding claims, wherein the conduit (60) is mechanically attached to the radiation shield (33).

9. The cryostat structure (30) according to one of the preceding claims, comprising a multi-layer insulation (38) covering a surface of the thermal radiation shield (33), wherein the conduit (60) extends through the multi-layer insulation (38) and wherein the conduit (60) is interfaced with the multi-layer insulation (38) by one or more sleeves (80) interleaved with layers of the multi-layer insulation (38).

10. The cryostat structure (30) according to one of the preceding claims, comprising a multi-layer insulation (38) covering a surface of the thermal radiation shield (33), wherein the conduit (60) is arranged in such a way that a section of the conduit (60) extends in parallel to the surface of the thermal radiation shield (33) along a section of the surface of the thermal radiation shield (33), wherein the conduit (60) extends through a hole (81) in the multi-layer insulation (38) and a hole in the thermal radiation shield (33), and wherein the hole (81) in the multi-layer insulation (38) is offset with respect to the hole in the thermal radiation shield (33).

11. The cryostat structure (30) according to one of the preceding claims, wherein the conduit (60) comprises a material having an intermediate thermal conductivity or a low thermal conductivity.

12. The cryostat structure (30) according to a preceding claim, comprising a second thermal radiation shield (34) enclosing the magnet space (72), wherein the conduit (60) extends through the wall of the thermal radiation shield (33) and a wall of the second thermal radiation shield (34) to fluidly connect the magnet space (72) and a volume within the vacuum region (71) outside the thermal radiation shield (33).

13. The cryostat structure (30) according to claim 12, wherein the conduit (60) is configured as a one-piece structure and comprises a material with low thermal conductivity.

14. The cryostat structure (30) according to claim 12, wherein the conduit (60) comprises a first section (60a) and a second section (60b) separated from each other, wherein the first section (60a) extends through the wall of the thermal radiation shield (33) and the second section (60b) extends through the wall of the second thermal radiation shield (34).

15. A magnetic resonance device (10), configured to acquire magnetic resonance data from an object positioned within an imaging region (14) of the magnetic resonance device (10), comprising a cryostat structure (30) according to one of the claims 1 to 14.
